# EUROPEAN PATENT SPECIFICATION

(11) **EP 2 340 440 B1**
(45) Date of publication and mention of the grant of the patent: **05.06.2019**
(21) Application number: 08875245.6
(22) Date of filing: 29.10.2008
(51) Int. Cl.: H02J 3/14, G01R 21/133, G01R 22/06, H02J 13/00

(54) **ELECTRICITY METER, REMOTE CONTROLLABLE DISCONNECTOR MODULE AND ELECTRICAL INSTALLATION COMPRISING THE ELECTRICITY METER**
ELEKTRIZITÄTSZÄHLER, FERNSTEUERBARES TRENNMODUL UND DEN ELEKTRIZITÄTSZÄHLER UMFASSENDE ELEKTRISCHE INSTALLATION
COMPTEUR ÉLECTRIQUE, MODULE DE DÉCONNEXION POUVANT ÊTRE COMMANDÉ À DISTANCE ET INSTALLATION ÉLECTRIQUE COMPRENANT LE COMPTEUR ÉLECTRIQUE

(43) Date of publication of application: 06.07.2011
(73) Proprietor: e-distribuzione S.p.A., 00198 Roma (IT)
(72) Inventor: VERONI, Fabio, 20059 Vimercate - Milano (IT)
(74) Representative: Hoffmann Eitle
(86) International application number: PCT/EP2008/064669
(87) International publication number: WO 2010/048993

(56) References cited:
- WO-A-92/07276
- WO-A1-2008/002336
- US-A- 4 075 699
- US-A- 4 308 511
- US-A1- 2006 221 521

## Description

In some countries, the delivery point in an electricity distribution network for the power company on the premises of a customer is marked by the fuse. Up to the fuse, the electricity network is owned by the power company. Beyond the fuse, the network is not in the ownership of the electric power company.

The electricity meter for measuring the consumption of electricity is arranged downstream of the fuse. In order to prevent that the customer bypasses the meter in order to be able to draw electricity from the network not counted by the meter, the portion of the electricity network between the fuse and the meter is inaccessible for the customer by means of appropriate protection measures.

WO 2008/002336 describes a method and apparatus for temperature-based load management metering in an electric power system. Here, a load monitor may be provided in an power meter assembly and be programmed such that a power authority can command a processor to allow no more than a specifief maximum amount of power (or current) is delivered through the load monitor. The load monitor device may receive a load-limit message from the power authority instructing the load monitor device to limit power. The load monitor device selects the circuits to shut down (based on the allowed current) and sends shutdown commands to various load control devices.

In order to limit the amount of supplied power, a so- called ICP or equivalent means is conventionally provided in the line from the electricity meter to the customer's premises. An ICP is a small circuit breaker with a thermal and a magnetic tripping function. If the power exceeds certain limits, the ICP is triggered to interrupt the electric load circuit. The customer can manually close the interrupted electrical load circuit by operating a lever or push button provided on the ICP. In order to avoid that a customer bypasses the ICP to exceed the maximum power agreed upon with the power company, the electric cable to the ICP from the electric meter is again protected and inaccessible by the customer.

It would be advantageous to move the power limitation function provided by the ICP into the electricity meter. This would allow for example that the power limit to be observed is determined by means of appropriately programming the electricity meter in accordance with the power limit subscribed by the individual customer, such that there would no longer be a need for a variety of ICPs with different power limits.

However, then provisions have to be taken to enable the customer to re-close the electric circuit without having to access the meter, after the power limitation function has opened the electrical circuit due to an overload condition. It would be feasible to remote control the power limitation switch inside electricity meter by the customer. However, this would entail the disadvantage that once the power limitation switch has interrupted the electrical load circuit, a separate power supply would have to be provided for the remote control unit at the customer premises. Alternatively, a shunt would be needed across the switch in order to provide the remote control with operating power. A battery supply of the remote control unit is unsatisfactory at least for reasons of costs and battery self discharge. A shunt across the switch would not be safe.

The present invention is defined in the independent claims. Advantageous embodiments are given in the dependent claims.

An electricity meter according to a further example not defined by the set of claims is an electricity meter for installation in or at a building accommodating a customer of an electric power company, for measuring the consumption of energy supplied to the customer comprises a power input for connection to an electric power supply circuit provided by the electric power company; a power output for supplying electric power to an electric load circuit associated with the customer; power measuring means for obtaining a measure of the power delivered to the electric load circuit; means for obtaining an amount of electric energy supplied to the electric load circuit; monitoring means for monitoring whether or not the measure of power delivered to the electric load circuit complies with a specified limit; command generating means for generating a disconnection command in response to the measure of the power exceeding the specified limit; and transmitter means for transmitting said disconnection command via power line communication over said electric load circuit connected to said power output to at least one remote controllable disconnector module arranged in the electric load circuit.

A remote controllable disconnector module according to a further example not defined by the set of claims is a remote controllable disconnector module for installation on the premises of a customer of an electric power company in an electric load circuit associated with the customer comprises an electric switch for connecting and disconnecting the electric load circuit; manual operating means for moving said electric switch into a connecting position upon manual action,- power line communication receiver means for receiving a disconnection command via power line communication from an electricity meter and generating a tripping signal in accordance with the received disconnection command; and means for causing said electric switch to move into a disconnecting position to interrupt the electric load circuit in response to the tripping signal.

The present invention also relates to an electrical installation on the premises of a customer.

According to an embodiment of the present invention, the electricity meter is provided with means for monitoring whether the power delivered to the customer complies with the subscribed power limit. In case the delivered power exceeds this limit, the meter sends a command to the remote controllable disconnector module by means of power line communication over the electric circuit section connecting the meter and the remote controllable disconnector module. In this arrangement, the meter performs monitoring the subscribed power limit but does not disconnect the electric load circuit if that limit is exceeded. Disconnection of the load circuit in case of exceeding the subscribed power limit is carried out by the switch located at the former ICP location in response to the command received from the meter.

According to an advantageous embodiment of this invention, a load management function can be integrated into the meter. The electric circuit downstream of the meter may comprise more than one load circuits connected in parallel. Each load circuit connected to the meter has its own remote controllable disconnector module individually remote controlled by the meter. If the subscribed power limit is exceeded by the customer, the meter would be able to switch off certain load circuits rather than all load circuits of the customer at once. In this way it would be possible e. g. to disconnect heavy load circuits like electric stoves while the refrigerators can be kept operating in the first instance.

In the following, preferred embodiments of the present invention will be described with reference to the accompanying drawings.
Fig. 1 shows an embodiment of an electrical installation on the premises of customers of an electric power company;
Fig. 2 shows an embodiment of an electricity meter and an example of a remote disconnector module in the electrical installation according to fig. 1;
Fig, 3 shows a specific example of a power limit monitored by a monitoring means according to an embodiment of the present invention;
Fig. 4 shows an embodiment of operation of an electricity meter; and
Fig. 5 shows an example of a rack mountable remote controllable disconnector module. In the figures the same reference numerals are used for the same or corresponding elements.

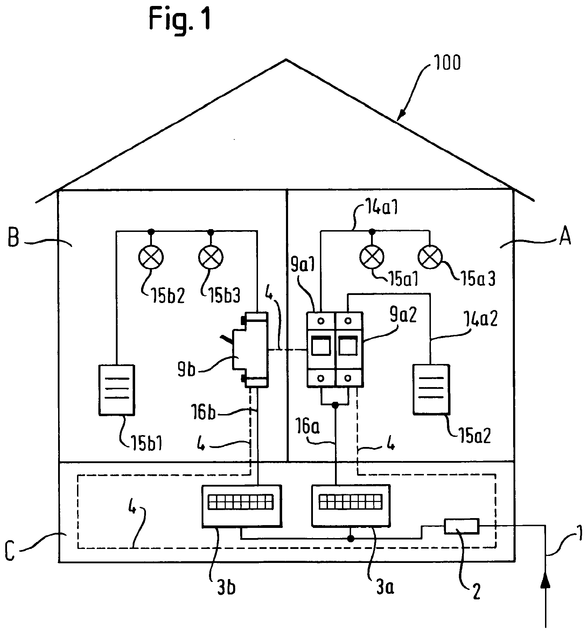

Fig. 1 shows an embodiment of an electrical installation on the premises of customers of an electric power company, In this figure, 100 denotes a building that accommodates a customer A, a customer B as well as a basement C. Reference numeral 1 denotes a power line coming from the electric power company supplying the building with customers A and B with electric power. The power line 1 comes from the outside of the building 100 and typically enters into the building 100 in the basement C. 2 denotes an electric fuse for disconnecting the building 100 from the power line 1 in case all other mechanisms for avoiding dangerous overload conditions in the electric installation of the building 100 should fail. Reference numerals 3a and 3b each denote electricity meters. The electricity meter 3a is associated with the customer A while the electricity meter 3b is associated with customer B. Each electricity meter 3a, 3b serves to measure the amount of electric energy consumed by the associated customer A respectively B and comprises display means in order to display the consumption of electrical energy by the respective customers .

The power output side of the electricity meter 3a is connected to the input side of remote control disconnector modules 9a1 and 9a2 through a section 16a of the electric circuit supplying customer A. An electric load circuit 14a1 of the customer A is connected to the output side of remote controllable disconnector module 9a1 • The electric load circuit 14a1 comprises loads 15a1 and 15a3 like electric lamps or electric stoves. The remote controllable disconnector module 9a1 in the electric circuit 16a, 14a1 from the electricity meter 3a to the loads 15al, 15a3 serves to connect and remote controllably disconnect the loads 15a1, 15a3 of the electric load circuit 14a1 of the customer A.

Reference numeral 14a2 denotes an electric load circuit supplying a load 15a2 that relies on the availability of power, a refrigerator for example. The remote disconnector module 9a2 serves to connect and remote controllably disconnect the load circuit 14a2 comprising the load 15a2. The remote disconnector module 9a1 serves to disconnect the loads 15a1, 15a3 from the electric circuit section 16a of customer A in response to a disconnection command from the electricity meter 3a addressed to the remote controllable disconnector module 9a1 over the power line 16a of the electric load circuit connected to the electricity meter 3a. The remote controllable disconnector module 9a2 serves to disconnect the load 15a2 from the electric load circuit in response to a disconnection command via power line communication from the electricity meter 3a addressed to the remote controllable disconnector module 9a2. When the power supplied to customer A exceeds the subscribed power limit, the electricity meter can thus respond by disconnecting in the first instance only the load circuit 14al while leaving the load circuit 14a2 connected, and disconnecting the load circuit 14a2 only if the overload condition prevails after the load circuit 14a1 has been disconnected.

The electric installation for the customer B is more simple. That installation comprises an electric circuit section 16b connecting the output side of the electricity meter 3b of the customer B to the input side of a single remote controllable disconnector module 9b of customer B.

15b1, 15b2 and 15b3 denote electric loads connected to the electric circuit section IGb of customer B. The remote controllable disconnector module serves to disconnect the loads 15b1, 15b2 and 15b3 from the electric circuit section 14a1 in response to a disconnection command sent by the electricity meter 3b over the power line 16b to the remote disconnector module 9b.

Each of the modules 9a1, 9a2, 9b has its own unique address known to the respective electricity meter to which the module is connected, in order to avoid that a disconnector module reacts to a command from an electricity meter not associated with that module. Each module 9a1, 9a2 , 9b has a leaver or push button or the like that is accessible by customer A and B, respectively, for operating the respective disconnector module to reconnect the load to the respective circuit section 16a, 16b.

Reference numeral 4 denote means for protecting the entire electrical installation up to and including the input side of the remote disconnector modules 9a1, 9a2 , 9b against manipulation by unauthorized persons. The means 4 render the electricity meters 3a, 3b as well as the sections 16a, 16b of the electric load circuit connected to the respective meters as well as the connection of the disconnector modules 9a, 9a2 to the electricity meter 3a and the connection of the disconnector module 9b to the electricity meter 3b inaccessible such that unauthorized persons are prevented from shunting out an electricity meter 3a, 3b in an attempt to tamper the measurement of consumed energy, and are prevented from shunting out a disconnector module 9a1, 9a2, 9b in an attempt to draw more current from the power line 1 than subscribed by the respective customer.

The means 4 may comprise e. g. the location of the electricity meters 3a, 3b in a locked room, placing the sections 16a, 16b of the electric circuit inside metallic pipes that prevent access without destroying the power line, the use of sealed covers protecting the terminals of the disconnector modules, and the like, as is well known as such.

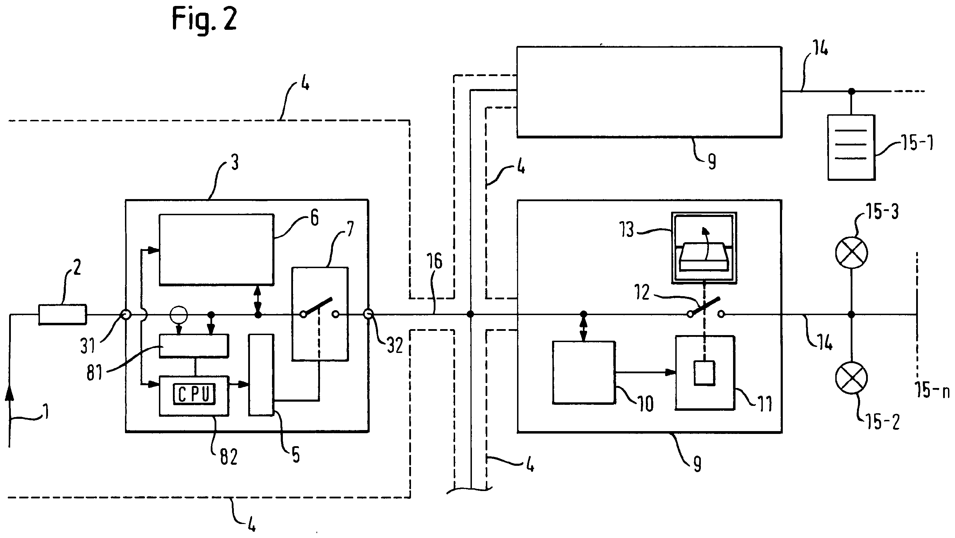

Fig. 2 shows an embodiment of an electricity meter 3 and an example of a remote disconnector module 9 not defined by the set of claims in an installation as shown in the example of Fig. 1.

The electricity meter 3 according to this embodiment comprises a power input terminal 31 for connection to an electric power supply circuit 1 provided by the electric power company. The electricity meter 3 furthermore comprises a power output terminal 32 for supplying electric power to the electric circuit section 16 and the loads associated with the customer. Reference numeral 81 denotes power measuring means for obtaining a measure of power delivered to the electric load circuit 16. The power measuring means 81 can be of any type well known as such for measuring power and can employ any suitable measure of power. In the embodiment shown, the power measuring means 81 measures the current flowing through the electricity meter and also measures the supply voltage. The power measuring means 81 then derives a power measure from the current value and voltage value thus obtained. For example, the power measuring means 81 calculates a product P(t) of the instantaneous current i (t) and the instantaneous voltage u{t) in the electric load circuit and calculates an average of the instantaneous power P(t) using a sliding window method to thus obtain a power measure. It has to be noted, however, that other ways of obtaining a power measure are equally useful and appropriate. According to a simplified and preferable example, the power measuring means only measures the current flowing through the electric load circuit 16 and uses the measured current as an estimate for the total power including the active power and the reactive power delivered to the load circuit 16.

Reference numeral 82 denotes a command generating means for generating a disconnection command in response to the measure of the power provided by the power measuring means 81 exceeding a specified limit. The command generating means 82 is preferably embodied by means of a microcontroller circuit having a central processing unit CPU.

The microcontroller circuit preferably also comprises storage means for storing a representation of the power limit subscribed by the respective customer. This power limit can be programmed into memory of the microcontroller circuit. The microcontroller circuit carries out a comparison of the measure of power provided by the power measuring means 81 with the power limit and supports a suitable communication protocol for carrying out power line communication between the electricity meter 3 and a remote controllable disconnector module 9.

Reference numeral 6 denotes a transmitter for transmitting the disconnection command provided by the command generating means 82 over the electric circuit section 16 connecting the power output 32 of the electricity meter 3 to the remote controllable disconnector module 9 arranged in the electric load circuit. Preferably, in order to enable a bidirectional communication between the remote controllable disconnector module 9 and the electricity meter 3, the means 6 is a transmitter receiver coupled to the electric load circuit 16 such that it can also receive power line communication signals transmitted by the module 9.

Preferably, the power line communication transceiver means 6 is adapted to receive commands and power limit information from the electric power company via the power line 1. This allows remote programming and changing of subscribed power limits without a need for maintenance personnel to access the building 100,
Reference numeral 7 denotes over current protection means provided in the electricity meter 3 that allows interrupting the output of power of the electricity meter 3. The over current protection means 7 can be tripped through driving means 5 in response to a signal from the microcontroller circuit. Tripping preferably takes place if the electric current supplied at the power output 32 of the electricity meter exceeds a specified current threshold for more than a specified period of time. This is a preferable safety measure that keeps the current flowing in the circuit 16 below a level harmful to the electric installation regardless whether the power line communication between the electricity meter 3 and the remote controllable disconnector module 9 is established or not .

For example, due to an error or temporary malfunction of the power line communication between the meter 3 and the module 9 a disconnection command sent by the meter 3 to the remote disconnection module 9 via power line communication might not result in that the power supplied to the electric load circuit 16 falls below the specified power limit subscribed by the customer.

If a specified number of attempts to remotely disconnect the load circuit by the remote control disconnection module 9 fails, the central processing unit can then trip the over current protection means 7 through the tripping means 5 in order to enforce the subscribed power limit. Reclosing the over current protection means 7 may then require the intervention of authorized maintenance personnel of the electric power company. Preferably, the central processing unit CPU writes information into memory of the microcontroller circuit that is readable by authorized maintenance personnel and reveals the cause why the over current protection means 7 was tripped.

In case tripping occurred due to the inability of the electricity meter 3 to successfully transmit a disconnection command to the remote controllable disconnector module 9, the maintenance personnel would then be in a position to investigate whether an attempt has been made to shunt out the remote controllable disconnector module 9 or manipulate in any other way the electrical installation with the aim to exceed the subscribed power limit.

The remote controllable disconnector module 9 according to the example not defined by the set of claims comprises an electric switch 12 for connecting and disconnecting the electric load circuit 14 downwstream of the remote controllable disconnector module 9.

Reference numeral 13 denotes manual operating means for moving the electric switch 12 into a connecting position upon manual action. In the connecting position, the electric load circuit 14 is connected through the switch 12 to the electric load circuit 16 and thus connected to the output of the electricity meter 32. The manual operating means 13 can be a lever or a push button arranged such that by means of moving the lever or pushing the push button the switch 12 can be closed. Preferably, the manual operating means furthermore allows opening the switch 12 to disconnect the section 14 of the electric load circuit, for example if maintenance work has to be carried out on anyone of the loads 15-1, ..., 15-n.

The manual operating means 13 furthermore allows the customer to reclose the switch 12 after the remote controllable disconnector module 9 has received and executed disconnection command from the electricity meter 3. Of course, before the customer manually recloses the switch 12, the condition that caused the power to exceed the subscribed power limit should have been removed.

Reference numeral 10 denotes a power line communication transceiver module coupled to the electric circuit section 16 in order to receive disconnection commands via power line communication from the transceiver 6 of the electricity meter 3 and in order to send commands like acknowledgement commands to the electricity meter 3. The power line communication transceiver 10 also comprises means for processing the received commands to output a tripping signal to means 11 and cause the electric switch 12 to move into a disconnecting position.

The means 11 for causing the electric switch 12 to move into a disconnecting position can be embodied in a number of different ways. For example, the means 11 may comprise a spring arranged such that the spring is loaded when the switch 12 is manually moved into the connecting position. The spring can then move the switch 12 into the disconnecting position when unloading, as soon as the spring is released by a movable member. The movable member in turn is arranged to cooperate with a coil for exerting magnetic forces on the movable member. As soon as an electric current flows through the coil in response to a tripping signal supplied by the transceiver 10, the movable member releases the spring such that the switch 12 disconnects the electric load circuit section 14. According to another embodiment the means 11 and the switch 12 are components of a bi-stable relay. In this embodiment, the manual operating means 13 comprises a push button that allows a customer to toggle the bi-stable relay into a disconnected position of the switch 12. The means 13 preferably includes a further button to manually move the relay switch back into the connected position. Numerous other possibilities exist to embody the means 11 for disconnecting the switch 12 and the manual operating means 13 all of which are suitable for application in a remote controllable disconnect module according to the present invention.

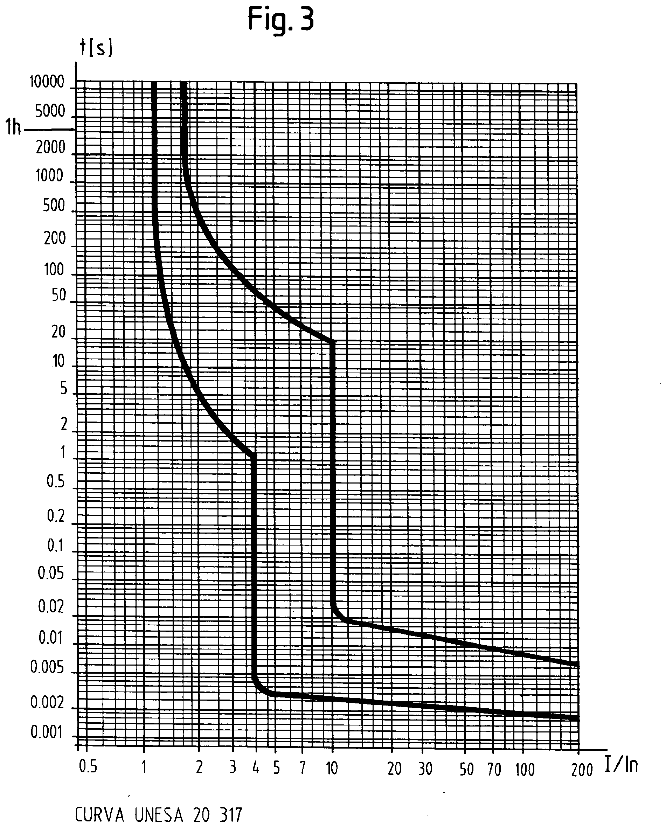

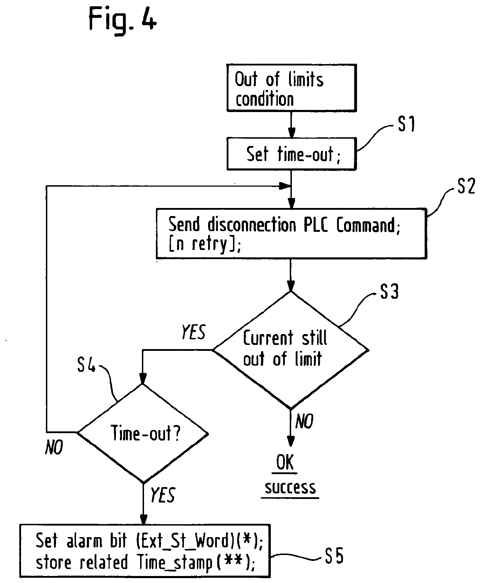

Fig, 3 shows a specific example of a diagram reflecting a specific power limit subscribed by a customer according to Unesa 20317. The horizontal axis in this diagram denotes the current I divided by the subscribed current In corresponding to the subscribed power limit. The product of I and of the rated supply voltage, typically 220 Volt in Western Europe yields the subscribed power limit. The vertical axis indicates the time it takes for the command generating means 82 of the electricity meter 3 to generate a disconnection command, as a function of the ratio of the over current I and the rate current In. When implementing the power limit according to Unesa 20317, the power command generating means 82 generates the disconnection command within a time interval defined by the lower curve and the upper curve in the diagram of Fig. 3 depending on the amount of current I/In. Fig 4 shows an embodiment of operation of an electricity meter 3 according to the present invention.

According to this embodiment, if a given measure of power has been detected to exceed the specified power limit subscribed by the customer, in step S1 a timeout is set by the central processing unit CPU of the electricity meter. This timeout is used for setting a maximum time period in which the execution of the disconnection command from the electricity meter by the remote controllable disconnector module 9 has to be successful. In step S2 the electricity meter 3 then sends a disconnection command via power line communication to the remote controllable disconnector module 9. In step S3 the CPU of the electricity meter 3 determines whether the current supplied by the electricity meter 3 is still above the power limit subscribed by the customer. If the result of this determination is NO, the procedure for processing the out of limit condition terminates successfully. If the determination result of step S3 is YES, this process proceeds to step S4. In S4 it is determined whether the timeout period set in step S1 has expired or not. If the timeout period has not yet expired, the procedure goes on to repeat the transmission of a disconnection command in step S2 and to again determine whether in response to the disconnection command, the current supplied through the electricity meter still remains above the subscribed limit.

This loop is repeated until either in step S3 the subscribed power limit is no longer exceeded, or in step S4 it is determined that the timeout period has expired. In case a timeout has occurred, step S5 is executed to set an alarm bit and store a related time stamp in memory of the electricity meter 3. Then, the electricity meter 3 generates a tripping command to trip the overcurrent protection means 7 in the electricity meter 3 in order to disconnect the entire circuit section 16 from the power line 1.

In case the electrical circuit connected to the electricity meter comprises more than one remote controllable disconnector modules, preferably the disconnection command in step S2 is sent at first to a first group of disconnector modules only. If after the timeout set in S1 the loop shown in Fig. 4 is left through step S4 via the affirmative branch (YES), another loop is entered into wherein in step S2 disconnection commands are sent to all remote controllable disconnector modules 9 associated with the respective customer. Only if that further loop is left after a further timeout via step S4 through the affirmative branch (YES), the alarm bit is set, a time stamp is stored and the overload protection means 7 is tripped inside the electricity meter 3.

Alternatively or in addition to step S3 the electricity meter may determine after emission of a disconnection command whether the remote controllable disconnector module has acknowledged the receipt of the disconnection command from the electricity meter 3 by means of a suitable acknowledgement message from the module 9 to the meter 3.

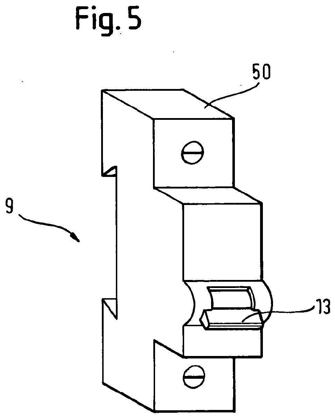

Fig. 5 shows an example of a rack mountable remote controllable disconnector module 9 not defined by the set of claims. According to this example, the components of the remote controllable disconnector module 9 are accommodated in a casing 50 that allows to rack mount the remote controllable disconnector module 9 in a distribution box for rendering accessible the manual operating means 13 to the customer. The distribution box not shown in the figure renders inaccessible the rear portions of the casing 50 as well as the top and bottom portions of the module 9 when mounted in the box, such that the connector terminals of the remote controllable disconnector module 9 (not shown in Fig. 5) can be provided at the back side of the module or at the top and at the bottom of the module 9.

According to an advantageous embodiment of the present invention, the electricity meter 3 is adapted to transmit an alarm message to the remote controllable disconnector module 9 when the measure of power is still below the subscribed power limit but above an alarm threshold specified in the electric meter 3. Alternatively or additionally, an alarm message is transmitted from the electricity meter 3 to the remote disconnector module 9 when the duration of the measure of power exceeding a limit specified in the electricity meter 3 exceeds a time limit also specified in the electricity meter 3. The remote controllable disconnector module preferably comprises audio and/or visual indication means, for example a buzzer or a light emitting diode arrange visible for the customer at the front side of the disconnector module. Upon reception of an alarm message from the electricity meter 3, the disconnector module 9 operates the audio and/or visual indication means to provide a warning to the customer that the power consumed by the customer approaches the subscribed power limit.

It has to be noted that the embodiments described above referenced to figures 1 to 3 and 5 are no more than specific examples of carrying out the present invention. The present invention is, however, not limited to the embodiments shown and described. The scope of the present invention is defined by the appended claims.

## Claims

1. An electricity meter (3) for installation in or at a building (100) accommodating a customer (A, B) of an electric power company, for measuring the consumption of energy supplied to the customer (A, B), the electricity meter (3) comprising
a power input (31) for connection to an electric power supply circuit (1) provided by the electric power company;
a power output (32) for supplying electric power to an electric circuit (16) associated with the customer (A, B) ;
power measuring means (81) for obtaining a measure of power delivered to the electric circuit (16);
means (82) for obtaining an amount of electric energy supplied to the electric circuit (16);
monitoring means (82) for monitoring whether or not the measure of power delivered to the electric circuit (16) complies with a specified limit;
command generating means (82) for generating a disconnection command in response to the measure of power exceeding the specified limit, said command generating means (82) being embodied by means of a microcontroller circuit having a central processing unit;
transmitter means (6) for transmitting said disconnection command via power line communication over said electric circuit (16) connected to said power output (32) to at least one remote controllable disconnector module (9) arranged in the electric circuit (16, 14),
over current protection means (7) for interrupting the output of power of the electricity meter (3) in case the electric current supplied at the power output (32) of the electricity meter (3) exceeds a specified current threshold for more than a specified period of time, and driving means (5) for tripping said over current protection means (7) in response to a signal from the microcontroller circuit if the electricity power supplied at the power output (32) exceeds a specified current threshold for more than the specified period of time,
if the measure of power has been detected to exceed the specified limit,
the central processing unit of the electricity meter is configured to, in a first loop if the electric circuit (16) has one remote controllable disconnector module (9) :
- set a timeout period (S1), the timeout period being used for setting a maximum time period in which the execution of the disconnection command from the electricity meter by the remote controllable disconnector module (9) has to be successful,
- determine whether a current supplied by the electricity meter is still above the specified limit (S3),
- determine whether the set timeout period has expired or not (S4), if it is determined that the current supplied by the electricity meter is still above the specified limit,
- to repeat the transmission of said disconnection command if the specified timeout period has not yet expired, and
- if the timeout period has expired, to set an alarm bit and storing a related time stamp in a memory of the electricity meter (3) and to generate a tripping command for tripping said overcurrent protection means (7), and
if the electric circuit (16) has more than one remote controllable disconnector module (9) and if after the timeout set in the first loop the first loop is left by determining that the current supplied by the electricity meter is still above the specified limit, the central processing unit of the electricity meter is configured to:
- enter a further loop wherein disconnection commands are sent to all remote controllable disconnector modules (9) and to set the alarm bit, to store the time stamp and to trip said overcurrent protection means (7) only if the further loop is left after a further timeout period by determining that the current supplied by the electricity meter is still above the specified limit.

2. The electricity meter (3) according to claim 1, comprising
means (6) for receiving information from the electric power company regarding said specified limit;
said monitoring means (82) being adapted to adjust the specified limit in accordance with the received information.

3. The electricity meter (3) according to any one of the preceding claims, wherein
said command generating means (82) is adapted to selectively address said disconnection command to a first group (9a1) of one or more remote controllable disconnector modules among a plurality of remote controllable disconnector modules (9al, 9a2) connected to the power output (32) of the electricity meter (3a).

4. The electricity meter (3) according to any one of the preceding claims, comprising a casing for integrally accommodating and preventing unauthorized access to the components (5, 6, 7, 81, 82) of the electricity meter (3) .

5. The electricity meter (3) according to any one of the preceding claims, wherein
said measure of power is a level of current (I) delivered at the power output of the electricity meter to the electric load circuit (16); and
said specified limit is a time limit (t) for the current level (I) to exceed a specified rated current level (In), the time limit (t) depending on a ratio of the delivered current level (I) to said rated current level (In) .

6. The electricity meter (3) according to any one of the preceding claims, wherein said specified limit of said monitoring means follows the UNE-20.137 specification.

7. The electricity meter according to any one of the preceding claims, wherein said command generating means are adapted to carry out at least one of
generating an alarm message signal for transmission to the remote controllable disconnector module (9) when the power measure is below the specified limit but above a specified alarm threshold;
generating an alarm message signal for transmission to the remote controllable disconnector module (9) when the power measure is below the specified limit and the duration of the power measure being above a specified alarm threshold exceeds a specified time limit.

8. An electrical installation on the premises (100) of a customer (A, B) of an electric power company, the installation comprising
an electricity meter (3, 3a, 3b) according to any one of the preceding claims 1 to 7, the power input (31) of the electricity meter being connected to said electrical power supply circuit (1) provided by the electric power company;
an electric circuit (14, 16) connected to the power output (32) of the electricity meter (3, 3a, 3b) for supplying electric power to an electrical load (15) associated with the customer (A, B); and
means (4) for rendering inaccessible the electricity meter (3, 3a, 3b) and the electric power supply circuit (1) connected to the power input (31) of the electricity meter (3, 3a, 3b) for persons not authorized by the electric power company.

9. The electrical installation according to claim 8, comprising
a remote controllable disconnector module (9) comprising
an electric switch (12) for connecting and disconnecting an electric load circuit (14);
manual operating means (13) for moving said electric switch (12) into a connecting position upon manual action;
power line communication receiver means (10) for receiving a disconnection command via power line communication from an electricity meter (3) according to any one of the preceding claims 1 to 12 and generating a tripping signal in accordance with the received disconnection command;
means (11) for causing said electric switch (12) to move into a disconnecting position to disconnect the electric load circuit (14, 16) in response to the tripping signal;
the remote controllable disconnector module (9) being arranged in the electrical circuit (14, 16) connected to the power output (32) of the electricity meter (3, 3a,3b) ;
said manual operating means (13) of said remote controllable disconnector module (9) being provided accessible by the customer to allow the customer to manually cause said switch (12) of the remote controllable disconnector module (9) to move into a connecting position.

10. The electrical installation according to claim 9, comprising
means (4) for rendering a section (16) of the electric circuit which section connects the output (32) of the electricity meter (3, 3a, 3b) to the remote controllable disconnector module (9), inaccessible for persons not authorized by the electric power company.

11. The electrical installation according to any one of the claims 8 to 10, comprising a fuse (2) in the electrical power supply circuit (1) at the power input side (31) of the electricity meter (3, 3a, 3b).

12. A system for installation on the premises (100) of a customer (A, B) of an electric power company comprising an electricity meter according to any one of the preceding claims 1 to 7 and a remote controllable disconnector module (9), the remote controllable disconnector module (9) comprising
an electric switch (12) for connecting and disconnecting an electric load circuit (14);
manual operating means (13) for moving said electric switch (12) into a connecting position upon manual action;
power line communication receiver means (10) for receiving a disconnection command via power line communication from an electricity meter (3) according to any one of the claims 1 to 12 and generating a tripping signal in accordance with the received disconnection command;
means (11) for causing said electric switch (12) to move into a disconnecting position to disconnect the electric load circuit (14, 16) in response to the tripping signal;
wherein
the electric switch (12) is a bistable relay switch.

13. The system according to claim 12, wherein the remote controllable disconnector module (9) further comprises a casing (50) that allows to rack mount the remote controllable disconnector module (9) in a distribution box for rendering accessible the manual operating means (13) to the customer.

14. The system according to any one of the claims 12 to 13, wherein the remote controllable disconnector module (9) further comprises audio and/or visual indication means responsive to an alarm message received from the electricity meter to provide an alarm signal to the customer that the consumed power approaches the specified power limit.

## Patentansprüche

1. Elektrizitätszähler (3) zur Installation in oder an einem Gebäude (100), in dem ein Kunde (A, B) eines Elektrizitätsversorgungsunternehmens untergebracht ist, zum Messen des Verbrauchs der an den Kunden (A, B) gelieferten Energie, wobei der Elektrizitätszähler (3) umfasst
einen Leistungseingang (31) vom Verbinden mit einem Schaltkreis zur Versorgung mit elektrischer Leistung (1), der vom Elektrizitätsversorgungsunternehmen bereitgestellt ist;
einen Leistungsausgang (32) zum Versorgen eines mit dem Kunden (A, B) in Bezug stehenden elektrischen Schaltkreises (16) mit elektrischer Leistung;
Leistungsmessungsmittel (81) zum Erhalten eines Maßes von an den elektrischen Schaltkreis (16) abgegebener Leistung;
Mittel (82) zum Erhalten einer Menge von elektrischer Energie, die an den elektrischen Schaltkreis (16) abgegeben wurde;
Überwachungsmittel (82) zum Überwachen, ob das Maß von an den elektrischen Schaltkreis (16) abgegebener Leistung eine spezifizierte Begrenzung einhält oder nicht;
Befehl erzeugende Mittel (82) zum Erzeugen eines Abschaltungsbefehls als Reaktion darauf, dass das Maß von Leistung die spezifizierte Begrenzung übersteigt, wobei die Befehl erzeugenden Mittel (82) verkörpert sind durch Mittel eines Microcontroller-Schaltkreises, der eine zentrale Verarbeitungseinheit aufweist;
Sendermittel (6) zum Senden des Abschaltungsbefehls mittels Leistungsleitungskommunikation über den elektrischen Schaltkreis (16), der mit dem Leistungsausgang (32) verbunden ist, an mindestens ein fernsteuerbares Abschaltermodul (9), das im elektrischen Schaltkreis (16, 14) angeordnet ist,
Überstromschutzmittel (7) zum Unterbrechen der Ausgabe von Leistung vom Elektrizitätszähler (3), wenn der an den Leistungsausgang (32) des Elektrizitätszählers (3) abgegebene elektrische Strom einen spezifizierten Stromschwellwert länger als eine spezifizierte Zeitperiode übersteigt, und
antreibende Mittel (5) zum Auslösen der Überstromschutzmittel (7) als Reaktion auf ein Signal von dem Microcontroller-Schaltkreis, wenn die am Leistungsausgang (32) abgegebene Elektrizitätsleistung einen spezifizierten Stromschwellwert länger als die spezifizierte Zeitperiode übersteigt,
wobei, wenn erkannt wurde, dass das Maß an Leistung die spezifizierte Begrenzung übersteigt,
die zentrale Verarbeitungseinheit des Elektrizitätszählers ausgelegt ist, um in einer ersten Schleife, wenn der elektrische Schaltkreis (16) ein fernsteuerbares Abschaltermodul (9) aufweist:
- eine Zeitüberschreitungsperiode (S1) festzusetzen, wobei die Zeitüberschreitungsperiode zum Festsetzen einer maximalen Zeitperiode verwendet wird, in der die Ausführung des Abschaltungsbefehls vom Elektrizitätszähler durch das fernsteuerbare Abschaltermodul (9) erfolgreich sein muss,
- zu bestimmen, ob ein vom Elektrizitätszähler abgegebener Strom noch über der spezifizierten Begrenzung (S3) liegt,
- zu bestimmen, ob die festgesetzte Zeitüberschreitungsperiode abgelaufen ist oder nicht (S4), wenn bestimmt wird, dass der vom Elektrizitätszähler abgegebene Strom noch über der spezifizierten Begrenzung liegt,
- das Senden des Abschaltungsbefehls zu wiederholen, wenn die spezifizierte Zeitüberschreitungsperiode noch nicht abgelaufen ist, und
- wenn die Zeitüberschreitungsperiode abgelaufen ist, ein Alarmbit festzusetzen und einen damit in Bezug stehenden Zeitstempel in einem Speicher des Elektrizitätszählers (3) zu speichern und einen Auslösebefehl zum Auslösen der Überstromschutzmittel (7) zu erzeugen, und
wenn der elektrischen Schaltkreis (16) mehr als ein fernsteuerbares Abschaltermodul (9) aufweist, und wenn nach der in der ersten Schleife festgesetzten Zeitüberschreitung die erste Schleife verlassen wird durch Bestimmen, dass der vom Elektrizitätszähler abgegebene Strom noch über der spezifizierten Begrenzung liegt, die zentrale Verarbeitungseinheit des Elektrizitätszählers ausgelegt ist, um:
- in eine weitere Schleife einzutreten, in der Abschaltungsbefehle an alle fernsteuerbaren Abschaltermodule (9) gesendet werden, und das Alarmbit festzusetzen, den Zeitstempel zu speichern und die Überstromschutzmittel (7) nur dann auszulösen, wenn die weitere Schleife nach einer weiteren Zeitüberschreitungsperiode verlassen wird durch Bestimmen, dass der vom Elektrizitätszähler abgegebene Strom noch über der spezifizierten Begrenzung liegt.

2. Elektrizitätszähler (3) nach Anspruch 1, umfassend
Mittel (6) zum Empfangen von Informationen vom Elektrizitätsversorgungsunternehmen in Bezug auf die spezifizierte Begrenzung;
wobei die Überwachungsmittel (82) angepasst sind, um die spezifizierte Begrenzung gemäß den empfangenen Informationen zu regulieren.

3. Elektrizitätszähler (3) nach einem der vorstehenden Ansprüche, wobei
die Befehl erzeugende Mittel (82) angepasst sind, um selektiv den Abschaltungsbefehl an eine erste Gruppe (9a1) von einem oder mehreren fernsteuerbaren Abschaltermodulen unter einer Vielzahl von fernsteuerbaren Abschaltermodulen (9a1, 9a2), die mit dem Leistungsausgang (32) des Elektrizitätszählers (3a) verbunden sind, zu richten.

4. Elektrizitätszähler (3) nach einem der vorstehenden Ansprüche, umfassend ein Gehäuse zur integralen Unterbringung und zum Verhindern von unbefugtem Zugang zu den Komponenten (5, 6, 7, 81, 82) des Elektrizitätszählers (3).

5. Elektrizitätszähler (3) nach einem der vorstehenden Ansprüche, wobei
das Maß von Leistung ein Pegel von am Leistungsausgang des Elektrizitätszählers an den elektrischen Laststromkreis (16) angegebenem Strom (I) ist; und
die spezifizierte Begrenzung eine Zeitbegrenzung (t) dafür ist, dass der Strompegel (I) einen spezifizierten Nennstrompegel (In) übersteigt, wobei die Zeitbegrenzung (t) von einem Verhältnis des abgegebenen Strompegels (I) zum Nennstrompegel (In) anhängig ist.

6. Elektrizitätszähler (3) nach einem der vorstehenden Ansprüche, wobei die spezifizierte Begrenzung der Überwachungsmittel der Spezifikation UNE-20.137 folgt.

7. Elektrizitätszähler nach einem der vorstehenden Ansprüche, wobei die Befehl erzeugenden Mittel angepasst sind, um mindestens eines auszuführen von
Erzeugen eines Alarmmeldungssignals zum Senden an das fernsteuerbare Abschaltermodul (9), wenn das Leistungsmaß unter der spezifizierten Begrenzung, aber über einem spezifizierten Alarmschwellwert liegt;
Erzeugen eines Alarmmeldungssignals zum Senden an das fernsteuerbare Abschaltermodul (9), wenn das Leistungsmaß unter der spezifizierten Begrenzung liegt und die Dauer, während der das Leistungsmaß über einem spezifizierten Alarmschwellwert liegt, eine spezifizierte Zeitbegrenzung übersteigt.

8. Elektrische Installation in den Räumlichkeiten (100) eines Kunden (A, B) eines Elektrizitätsversorgungsunternehmens, wobei die Installation umfasst
einen Elektrizitätszähler (3, 3a, 3b) nach einem der vorstehenden Ansprüche 1 bis 7, wobei der Leistungseingang (31) des Elektrizitätszählers mit dem Schaltkreis zur Versorgung mit elektrischer Leistung (1), der vom Elektrizitätsversorgungsunternehmen bereitgestellt ist, verbunden ist;
einen elektrischen Schaltkreis (14, 16), der mit dem Leistungsausgang (32) des Elektrizitätszählers (3, 3a, 3b) verbunden ist, zum Versorgen einer mit dem Kunden (A, B) in Bezug stehenden elektrischen Last (15) mit elektrischer Leistung; und
Mittel (4), um den Elektrizitätszähler (3, 3a, 3b) und den mit dem Leistungseingang (31) des Elektrizitätszählers (3, 3a, 3b) verbundenen Schaltkreis zur Versorgung mit elektrischer Leistung (1) für nicht vom Elektrizitätsversorgungsunternehmen befugte Personen unzugänglich zu machen.

9. Elektrische Installation nach Anspruch 8, umfassend
ein fernsteuerbares Abschaltermodul (9), umfassend
einen elektrischen Schalter (12) zum Einschalten und Abschalten eines elektrischen Laststromkreises (14);
manuelle Bedienungsmittel (13) zum Bewegen des elektrischen Schalters (12) in eine Einschaltposition nach manueller Betätigung;
Empfängermittel für Leistungsleitungskommunikation (10) zum Empfangen eines Abschaltungsbefehls mittels Leistungsleitungskommunikation von einem Elektrizitätszähler (3) nach einem der vorstehenden Ansprüche 1 bis 12 und Erzeugen eines Auslösesignals gemäß dem empfangenen Abschaltungsbefehl;
Mittel (11), um zu verursachen, dass sich der elektrische Schalter (12) in eine Abschalteposition bewegt, um den elektrischen Laststromkreis (14, 16) als Reaktion auf das Auslösesignal abzuschalten;
wobei das fernsteuerbare Abschaltermodul (9) in dem mit dem Leistungsausgang (32) des Elektrizitätszählers (3, 3a, 3b) verbundenen elektrischen Schaltkreis (14, 16) angeordnet ist;
wobei die manuellen Bedienungsmittel (13) des fernsteuerbaren Abschaltermoduls (9) für den Kunden zugänglich bereitgestellt sind, um es dem Kunden zu ermöglichen, zu verursachen, dass sich der Schalter (12) des fernsteuerbaren Abschaltermoduls (9) manuell in eine Einschaltposition bewegt.

10. Elektrische Installation nach Anspruch 9, umfassend
Mittel (4) um einen Abschnitt (16) des elektrischen Schaltkreises, wobei der Abschnitt die Ausgabe (32) des Elektrizitätszählers (3, 3a, 3b) mit dem fernsteuerbaren Abschaltermodul (9) verbindet, für nicht vom Elektrizitätsversorgungsunternehmen befugte Personen unzugänglich zu machen.

11. Elektrische Installation nach einem der Ansprüche 8 bis 10, umfassend eine Sicherung (2) im Schaltkreis zur Versorgung mit elektrischer Leistung (1) an der Leistungseingangsseite (31) des Elektrizitätszählers (3, 3a, 3b).

12. System zur Installation in den Räumlichkeiten (100) eines Kunden (A, B) eines Elektrizitätsversorgungsunternehmen, umfassend einen Elektrizitätszähler nach einem der vorstehenden Ansprüche 1 bis 7 und ein fernsteuerbares Abschaltermodul (9), wobei das fernsteuerbare Abschaltermodul (9) umfasst
einen elektrischen Schalter (12) zum Einschalten und Abschalten eines elektrischen Laststromkreises (14);
manuelle Bedienungsmittel (13) zum Bewegen des elektrischen Schalters (12) in eine Einschaltposition nach manueller Betätigung;
Empfängermittel für Leistungsleitungskommunikation (10) zum Empfangen eines Abschaltungsbefehls mittels Leistungsleitungskommunikation von einem Elektrizitätszähler (3) nach einem der vorstehenden Ansprüche 1 bis 12 und Erzeugen eines Auslösesignals gemäß dem empfangenen Abschaltungsbefehl;
Mittel (11), um zu verursachen, dass sich der elektrische Schalter (12) in eine Abschalteposition bewegt, um den elektrischen Laststromkreis (14, 16) als Reaktion auf Auslösesignal abzuschalten;
wobei
der elektrische Schalter (12) ein bistabiler Relaisschalter ist.

13. System nach Anspruch 12, wobei das fernsteuerbares Abschaltermodul (9) weiter ein Gehäuse (50) umfasst, das es erlaubt, das fernsteuerbare Abschaltermodul (9) in einem Verteilerkasten in einem Gestell einzubauen, um die manuellen Bedienungsmittel (13) für den Kunde unzugänglich zu machen.

14. System nach einem der Ansprüche 12 bis 13, wobei das fernsteuerbare Abschaltermodul (9) weiter Audio- und/oder visuelle Anzeigemittel umfasst, die auf eine vom Elektrizitätszähler empfangene Alarmmeldung ansprechen, um dem Kunden ein Alarmsignal bereitzustellen, dass sich die verbrauchte Leistung der spezifizierten Leistungsbegrenzung annähert.

## Revendications

1. Compteur électrique (3) destiné à être installé dans ou au niveau d'un bâtiment (100) accueillant un client (A, B) d'une compagnie d'électricité, pour mesurer la consommation d'énergie fournie au client (A, B), le compteur électrique (3) comprenant
une entrée de puissance (31) destinée à être connectée à un circuit d'alimentation en puissance électrique (1) pourvu par la compagnie d'électricité ;
une sortie de puissance (32) pour délivrer de la puissance électrique à un circuit électrique (16) associé au client (A, B) ;
des moyens de mesure de puissance (81) pour obtenir une mesure de puissance délivrée au circuit électrique (16) ;
des moyens (82) pour obtenir une quantité d'énergie électrique fournie au circuit électrique (16) ;
des moyens de contrôle (82) pour contrôler si la mesure de puissance délivrée au circuit électrique (16) est conforme ou non à une limite spécifiée ;
des moyen de génération d'instruction (82) pour générer une instruction de déconnexion en réponse à la mesure de puissance dépassant la limite spécifiée, lesdits moyens de génération d'instruction (82) étant réalisés au moyen d'un circuit de microcommande ayant une unité centrale de traitement ;
des moyens transmetteurs (6) pour transmettre ladite instruction de déconnexion, via une communication sur ligne de puissance sur ledit circuit électrique (16) connecté à ladite sortie de puissance (32), à au moins un module de déconnexion commandable à distance (9) agencé dans le circuit électrique (16, 14),
des moyens de protection contre des surintensités (7) pour interrompre la sortie de puissance du compteur électrique (3) dans le cas où le courant électrique fourni à la sortie de puissance (32) du compteur électrique (3) dépasse un seuil de courant spécifié pendant plus longtemps qu'une période de temps spécifiée, et
des moyens d'attaque (5) pour déclencher lesdits moyens de protection contre des surintensités (7) en réponse à un signal provenant du circuit de microcommande si la puissance électrique fournie au niveau de la sortie de puissance (32) dépasse un seuil de courant spécifié pendant plus longtemps que la période de temps spécifiée,
si la mesure de puissance a été détectée comme dépassant la limite spécifiée,
l'unité centrale de traitement du compteur électrique est configurée pour, dans une première boucle si le circuit électrique (16) comporte un module de déconnexion commandable à distance (9) :
- établir une période de temporisation (S1), la période de temporisation étant utilisée pour établir une période de temps maximale au cours de laquelle l'exécution de l'instruction de déconnexion provenant du compteur électrique par le module de déconnexion commandable à distance (9) doit avoir réussi,
- déterminer si un courant fourni par le compteur électrique est toujours supérieur à la limite spécifiée (S3),
- déterminer si la période de temporisation établie a expiré ou non (S4), s'il est déterminé que le courant fourni par le compteur électrique est toujours supérieur à la limite spécifiée,
- répéter la transmission de ladite instruction de déconnexion si la période de temporisation spécifiée n'a pas encore expiré, et
- si la période de temporisation a expiré, établir un bit d'alarme et stocker un horodatage associé dans une mémoire du compteur électrique (3) et générer une instruction de déclenchement pour déclencher lesdits moyens de protection contre des surintensités (7), et
si le circuit électrique (16) comporte plus d'un module de déconnexion commandable à distance (9) et si, après la période de temporisation établie dans la première boucle, la première boucle est quittée en déterminant que le courant fourni par le compteur électrique est toujours supérieur à la limite spécifiée, l'unité centrale de traitement du compteur électrique est configurée pour :
- entrer dans une autre boucle dans laquelle des instructions de déconnexion sont envoyées à tous les modules de déconnexion commandables à distance (9) et établir le bit d'alarme, pour stocker l'horodatage et déclencher lesdits moyens de protection contre des surintensités (7) uniquement si l'autre boucle est quittée après une autre période de temporisation en déterminant que le courant fourni par le compteur électrique est toujours supérieur à la limite spécifiée.

2. Compteur électrique (3) selon la revendication 1, comprenant
des moyens (6) pour recevoir des informations de la compagnie d'électricité concernant ladite limite spécifiée ;
lesdits moyens de contrôle (82) étant adaptés pour ajuster la limite spécifiée en fonction des informations reçues.

3. Compteur électrique (3) selon l'une quelconque des revendications précédentes, dans lequel
lesdits moyens de génération d'instruction (82) sont adaptés pour adresser sélectivement ladite instruction de déconnexion à un premier groupe (9a1) d'un ou plusieurs modules de déconnexion commandables à distance parmi une pluralité de modules de déconnexion commandables à distance (9a1, 9a2) connectés à la sortie de puissance (32) du compteur électrique (3a).

4. Compteur électrique (3) selon l'une quelconque des revendications précédentes, comprenant un boîtier pour loger intégralement et empêcher un accès non autorisé aux composants (5, 6, 7, 81, 82) du compteur électrique (3).

5. Compteur électrique (3) selon l'une quelconque des revendications précédentes, dans lequel
ladite mesure de puissance est un niveau de courant (I) délivré au niveau de la sortie de puissance du compteur électrique au circuit de charge électrique (16) ; et
ladite limite spécifiée est une limite de temps (t) pour que le niveau de courant (I) dépasse un niveau de courant nominal spécifié (In), la limite de temps (t) étant en fonction du rapport entre le niveau de courant délivré (I) et ledit niveau de courant nominal (In).

6. Compteur électrique (3) selon l'une quelconque des revendications précédentes, dans lequel ladite limite spécifiée desdits moyens de contrôle est conforme à la spécification UNE-20.137.

7. Compteur électrique selon l'une quelconque des revendications précédentes, dans lequel lesdits moyens de génération d'instruction sont adaptés pour effectuer au moins l'une des étapes suivantes :
générer un signal de message d'alarme à transmettre au module de déconnexion commandable à distance (9) lorsque la mesure de puissance est inférieure à la limite spécifiée mais supérieure à un seuil d'alarme spécifié ;
générer un signal de message d'alarme à transmettre au module de déconnexion commandable à distance (9) lorsque la mesure de puissance est inférieure à la limite spécifiée et la durée de la mesure de puissance qui est supérieure à un seuil d'alarme spécifié dépasse une limite de temps spécifiée.

8. Installation électrique dans les locaux (100) d'un client (A, B) d'une compagnie d'électricité, l'installation comprenant
un compteur électrique (3, 3a, 3b) selon l'une quelconque des revendications précédentes 1 à 7, l'entrée de puissance (31) du compteur électrique étant connectée audit circuit d'alimentation en puissance électrique (1) pourvu par la compagnie d'électricité ;
un circuit électrique (14, 16) connecté à la sortie de puissance (32) du compteur électrique (3, 3a, 3b) pour délivrer de la puissance électrique à une charge électrique (15) associée au client (A, B) ; et
des moyens (4) pour rendre inaccessible le compteur électrique (3, 3a, 3b) et le circuit d'alimentation en puissance électrique (1) connecté à l'entrée d'énergie (31) du compteur électrique (3, 3a, 3b) à des personnes non autorisées par la compagnie d'électricité.

9. Installation électrique selon la revendication 8, comprenant
un module de déconnexion commandable à distance (9) comprenant
un commutateur électrique (12) pour connecter et déconnecter un circuit de charge électrique (14) ;
des moyens d'actionnement manuel (13) pour déplacer ledit commutateur électrique (12) dans une position de connexion lors d'une action manuelle ;
des moyens récepteurs de communication sur ligne de puissance (10) pour recevoir une instruction de déconnexion via une communication sur ligne de puissance en provenance d'un compteur électrique (3) selon l'une quelconque des revendications précédentes 1 à 12 et générer un signal de déclenchement conformément à l'instruction de déconnexion reçue ;
des moyens (11) pour amener ledit commutateur électrique (12) à se déplacer dans une position de déconnexion pour déconnecter le circuit de charge électrique (14, 16) en réponse au signal de déclenchement ;
le module de déconnexion commandable à distance (9) étant agencé dans le circuit électrique (14, 16) connecté à la sortie de puissance (32) du compteur électrique (3, 3a, 3b) ;
lesdits moyens d'actionnement manuel (13) dudit module de déconnexion commandable à distance (9) étant rendus accessibles au client pour permettre au client de faire passer manuellement ledit commutateur (12) du module de déconnexion commandable à distance (9) dans une position de connexion.

10. Installation électrique selon la revendication 9, comprenant
des moyens (4) pour rendre une section (16) du circuit électrique, laquelle section connecte la sortie (32) du compteur électrique (3, 3a, 3b) au module de déconnexion commandable à distance (9), inaccessible à des personnes non autorisées par la compagnie d'électricité.

11. Installation électrique selon l'une quelconque des revendications 8 à 10, comprenant un fusible (2) dans le circuit d'alimentation en puissance électrique (1) du côté entrée de puissance (31) du compteur électrique (3, 3a, 3b).

12. Système destiné à être installé dans les locaux (100) d'un client (A, B) d'une compagnie d'électricité comprenant un compteur électrique selon l'une quelconque des revendications précédentes 1 à 7 et un module de déconnexion commandable à distance (9), le module de déconnexion commandable à distance (9) comprenant
un commutateur électrique (12) pour connecter et déconnecter un circuit de charge électrique (14) ;
des moyens d'actionnement manuel (13) pour déplacer ledit commutateur électrique (12) dans une position de connexion lors d'une action manuelle ;
des moyens récepteurs de communication sur ligne de puissance (10) pour recevoir une instruction de déconnexion via une communication sur ligne de puissance en provenance d'un compteur électrique (3) selon l'une quelconque des revendications 1 à 12 et générer un signal de déclenchement conformément à l'instruction de déconnexion reçue ;
des moyens (11) pour amener ledit commutateur électrique (12) à se déplacer dans une position de déconnexion pour déconnecter le circuit de charge électrique (14, 16) en réponse au signal de déclenchement ;
dans lequel
le commutateur électrique (12) est un commutateur à relais bistable.

13. Système selon la revendication 12, dans lequel le module de déconnexion commandable à distance (9) comprend en outre un boîtier (50) qui permet de monter en rack le module de déconnexion commandable à distance (9) dans une boîte de distribution pour rendre accessibles les moyens d'actionnement manuel (13) au client.

14. Système selon l'une quelconque des revendications 12 à 13, dans lequel le module de déconnexion commandable à distance (9) comprend en outre des moyens d'indication audio et/ou visuelle sensibles à un message d'alarme reçu du compteur électrique pour pourvoir un signal d'alarme au client indiquant que la puissance consommée s'approche de la limite de puissance spécifiée.
